# FASCICULE DE BREVET EUROPEEN

(11) **EP 1 365 444 B1**
(45) Date de publication et mention de la délivrance du brevet: **02.08.2006**
(21) Numéro de dépôt: 03354044.4
(22) Date de dépôt: 15.05.2003
(51) Int. Cl.: H01L 21/02, H01L 23/522

(54) **Condensateur en tranchées dans un substrat avec deux électrodes flottantes et indépendantes du substrat**
Grabenkondensator mit zwei vom Substrat unabhängigen Elektroden
Trench capacitor having two electrodes independent from the substrate

(30) Priorité: 15.05.2002 FR 0205965
(43) Date de publication de la demande: 26.11.2003
(73) Titulaire: STMicroelectronics S.A., 92120 Montrouge (FR)
(72) Inventeur: Delpech, Philippe, 38240 Meylan (FR); Cremer, Sébastien, 38000 Grenoble (FR); Marty, Michel, 38760 Saint-Paul de Varces (FR)
(74) Mandataire: de Beaumont, Michel

(56) Documents cités:
- EP-A- 1 020 928
- US-A1- 2002 025 609
- US-B1- 6 362 012

## Description

La présente invention concerne la réalisation dans des circuits intégrés de condensateurs de capacité élevée et utilisés notamment comme condensateurs de filtrage, de découplage et de liaison.

Nous appellerons par la suite capacité surfacique la valeur de capacité par unité de surface d'un condensateur plan, et capacité spécifique la valeur de capacité par unité de surface projetée sur le plan du substrat d'un condensateur réalisé en trois dimensions.

On connaît des condensateurs dits "intermétalliques" réalisés entre des couches métalliques formées au dessus d'un circuit intégré pour assurer des interconnexions. Pour réaliser ces condensateurs, il est nécessaire de former une couche diélectrique de constante diélectrique la plus élevée possible, et éventuellement une couche métallique supplémentaire proche d'une des couches métalliques utilisées pour les interconnexions.

Un condensateur intermétallique est divulgué dans le document EP-A-1 020 928.

Un inconvénient majeur de ces condensateurs est que la surface occupée est très importante et donc que le coût des circuits utilisant de tels condensateurs est élevé.

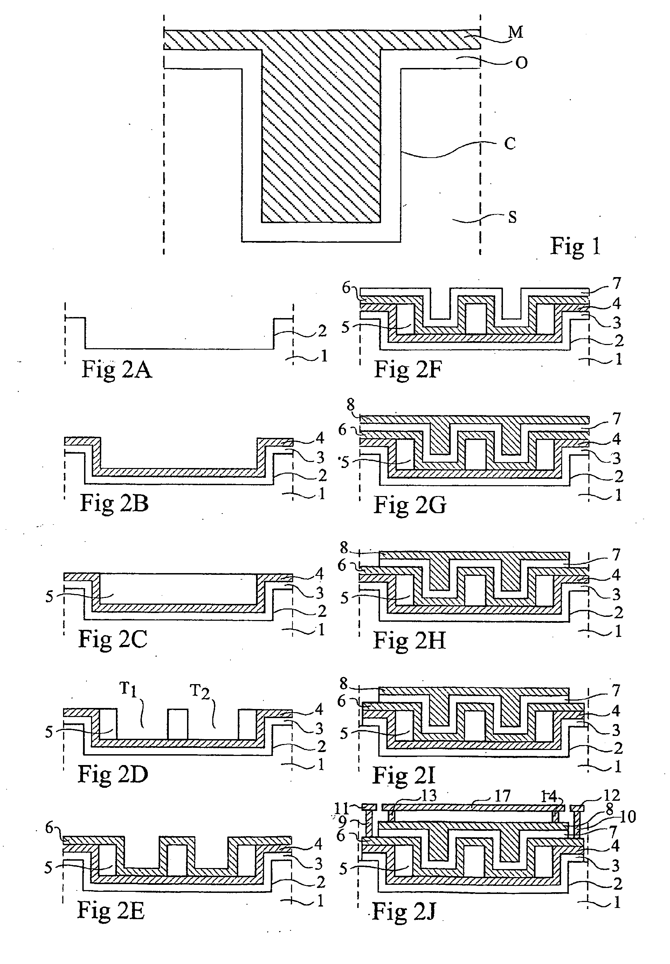

La figure 1 est une vue en coupe d'un autre type de condensateur réalisé dans un substrat semiconducteur S qui constitue la première électrode du condensateur. Un évidement C est creusé dans le substrat S. L'évidement est recouvert d'une couche d'oxyde O, elle-même recouverte d'une couche métallique M qui constitue la seconde électrode du condensateur. L'inconvénient principal de cette solution est que la première électrode est reliée au substrat et par conséquent sa tension de polarisation est fixe (à la masse). Ce type de condensateur est principalement utilisé en découplage.

La présente invention vise à proposer un procédé de formation de condensateurs de capacité spécifique supérieure à celle des condensateurs précédemment mentionnés.

Un autre objet de la présente invention est de proposer un tel procédé qui permette d'obtenir des condensateurs de résistance d'accès réduite.

Un autre objet de la présente invention est de proposer un tel procédé qui permette d'obtenir des condensateurs avec deux électrodes flottantes.

Pour atteindre ces objets, la présente invention prévoit un procédé de fabrication d'un condensateur dans un substrat, comprenant les étapes suivantes :
a) creuser un évidement dans le substrat ;
b) former une première couche conforme d'un matériau isolant ;
c) former une deuxième couche conforme conductrice ;
d) former une troisième couche de matériau conducteur ou isolant remplissant l'évidement ;
e) creuser des tranchées dans la troisième couche, sur toute la hauteur de cette dernière ;
f) déposer une quatrième couche d'un matériau conducteur ;
g) former une cinquième couche d'un matériau diélectrique ; et
h) déposer une sixième couche d'un matériau conducteur.

Selon un mode de réalisation de la présente invention, le procédé comprend entre les étapes d) et e) les étapes consistant à déposer une ou plusieurs couches de matériaux isolants correspondant à des couches isolantes intermétalliques ; et graver des tranchées dans lesdites une ou plusieurs couches de matériaux isolants.

Selon un mode de réalisation de la présente invention, le procédé comprend entre les étapes de dépôt et de gravure les étapes consistant à déposer une ou plusieurs couches de matériaux conducteurs correspondant à des couches métalliques d'interconnexion ; et graver des tranchées dans lesdites une ou plusieurs couches de matériaux conducteurs.

La présente invention prévoit aussi un condensateur réalisé dans un substrat comprenant un évidement creusé dans un substrat ; une première couche d'un matériau diélectrique recouvrant les parois, le fond et les bords de l'évidement ; une deuxième couche d'un matériau conducteur recouvrant la première couche ; une troisième couche d'un matériau conducteur ou isolant remplissant l'évidement ; des tranchées traversant la troisième couche ; une quatrième couche d'un matériau conducteur recouvrant les parois, les fonds ainsi que les intervalles entre ces tranchées et les bords de celles-ci ; une cinquième couche d'un matériau diélectrique recouvrant la quatrième couche ; et une sixième couche d'un matériau conducteur recouvrant la cinquième couche.

Selon un mode de réalisation de la présente invention, le condensateur comprend une ou plusieurs couches de matériaux isolants correspondant à des couches isolantes intermétalliques ; et des tranchées traversant lesdites une ou plusieurs couches de matériaux isolants.

Selon un mode de réalisation de la présente invention, le condensateur comprend une ou plusieurs couches de matériaux conducteurs correspondant à des couches métalliques d'interconnexion ; et des tranchées traversant lesdites une ou plusieurs couches de matériaux conducteurs.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles:
la figure 1 est une vue en coupe partielle d'un condensateur selon l'art antérieur ;
les figures 2A à 2J sont une succession de vues en coupe partielles et schématiques illustrant un procédé de réalisation d'un condensateur selon la présente invention ;
la figure 3 est une vue en coupe schématique d'un condensateur selon une variante de réalisation de la présente invention ;
la figure 4 est une vue en coupe schématique d'un condensateur selon une autre variante de réalisation de la présente invention ;
la figure 5 est une vue en perspective de dessus d'un exemple de réalisation d'un condensateur selon la présente invention ; et
la figure 6 est une vue en perspective de dessus d'un autre exemple de réalisation d'un condensateur selon la présente invention.

Un mode de réalisation d'un condensateur selon la présente invention est illustré en figures 2A à 2J qui sont des vues en coupe partielles et schématiques d'étapes successives du procédé selon l'invention. Comme cela est classique pour la représentation des circuits intégrés, les diverses figures ne sont pas tracées à l'échelle.

Comme l'illustre la figure 2A, une première étape du procédé selon l'invention consiste à creuser dans un substrat 1 un évidement 2. De façon classique, le substrat 1 est un matériau semiconducteur tel que du silicium dopé ou non dopé. On peut également réaliser le substrat avec du verre ou tout autre matériau. L'évidement 2 est creusé selon un procédé de gravure anisotrope classique permettant d'obtenir un évidement profond. A titre d'exemple, la profondeur de l'évidement peut être d'environ 20 micromètres.

Comme l'illustre la figure 2B, le procédé se poursuit par la formation d'une couche isolante 3 recouvrant le fond, les parois et les bords de l'évidement 2. La couche isolante peut être du dioxyde de silicium (SiO₂) obtenu par croissance thermique ou par dépôt selon un procédé classique.

La couche isolante 3 est ensuite recouverte d'une couche conductrice 4 déposée par exemple par voie chimique en phase vapeur (CVD) ou par voie physique (PVD). La couche conductrice 4 pourra être un matériau fortement conducteur tel que du cuivre, de l'aluminium, du tungstène ou analogue. Dans le cas où le condensateur selon le procédé présentement décrit est réalisé avant d'autres étapes impliquant un recuit à température élevée, il pourra être préférable d'utiliser des matériaux tels que du silicium polycristallin qui sont peu susceptibles de se détériorer et de se diffuser dans le reste de la structure.

La couche conductrice 4 constitue une partie de la première électrode du condensateur selon la présente invention. On peut d'ores et déjà noter qu'il existe un condensateur parasite entre la première électrode du condensateur et le substrat 1. Cependant la capacité de ce condensateur parasite peut être rendue négligeable en définissant de façon adéquate l'épaisseur de la couche isolante 3. Afin de faciliter l'évaluation de la capacité de ce condensateur parasite en fonction de la forme, et de la taille de l'évidement 2, il est préférable que la couche isolante 3 soit d'épaisseur constante. De même, la résistance d'accès à la première électrode du condensateur est fonction de l'épaisseur de la couche conductrice 4 que l'on pourra aisément ajuster. Il sera là aussi plus aisé de calculer la résistance d'accès si la couche conductrice 4 a une épaisseur constante.

Comme l'illustre la figure 2C, l'étape suivante du procédé selon l'invention consiste à remplir l'évidement, précédemment recouvert des couches 3 et 4, d'une couche de remplissage 5. Afin d'obtenir un condensateur de capacité maximale, l'épaisseur de la couche de remplissage sera prévue au moins égale à la hauteur de l'évidement. La couche de remplissage 5 peut être en un matériau isolant, semiconducteur ou éventuellement conducteur. Dans le cas d'un matériau isolant, ce peut être du SiO₂ déposé par voie chimique en phase vapeur (CVD). L'avantage d'utiliser une couche de remplissage 5 conductrice est de rendre la résistance d'accès négligeable.

Afin d'obtenir une épaisseur constante pour la couche de remplissage 5 quelle que soit la taille de l'évidement, on pourra réaliser un polissage mécano-chimique (CMP). De préférence la couche de remplissage 5 sera polie jusqu'à atteindre le niveau supérieur de la couche conductrice 4. L'utilisation de structures factices (dummies), telles que des piliers de substrat laissés à l'intérieur de l'évidement, permettra éventuellement d'homogénéiser le polissage et d'obtenir des surfaces planes.

Comme l'illustre la figure 2D, l'étape suivante consiste à creuser une ou plusieurs tranchées T₁, T₂ sur toute la hauteur de la couche de remplissage 5. On pourra utiliser une technique de gravure anisotrope classique utilisant par exemple un masque dur en SiO₂ ou de la résine photosensible. Dans le cas où la couche de remplissage 5 est constituée d'un matériau isolant ou semiconducteur, on pourra aisément prévoir un procédé de gravure sélective s'arrêtant sur la couche métallique inférieure, 4. Dans le cas où la couche de remplissage 5 est composée d'un matériau conducteur, on utilisera un procédé de gravure qui puisse s'arrêter avant d'atteindre la couche isolante 3 de façon à ne pas couper la couche conductrice 4.

Comme l'illustre la figure 2E, le procédé se poursuit par le dépôt d'une couche conductrice 6 recouvrant les parois, les bords et le fond des tranchées T₁, T₂. Ce dépôt pourra être réalisé selon différentes techniques telles qu'un dépôt par voie chimique en phase vapeur sous faible pression (LPCVD) ou un dépôt par voie chimique sous phase vapeur de couches atomiques (ALCVD ou ALD) ou un dépôt en phase vapeur à base d'organométalliques (MOCVD). Le matériau déposé pour former la couche 6, sera choisi le plus conducteur possible, afin de limiter la résistance d'accès, et si nécessaire résistant à des températures élevées afin de limiter les détériorations et la diffusion de la couche 6. Ce pourra être du silicium polycristallin, du nitrure de titane (TiN), du nitrure de tantale (TaN) ou tout autre couche conductrice (Al, Cu, W, ...). Là aussi la conformité du dépôt facilitera le calcul de la résistance d'accès.

Comme l'illustre la figure 2F, le procédé se poursuit par une étape de formation d'une couche diélectrique 7 recouvrant les bords, les parois et le fond des tranchées. La couche diélectrique 7 pourra être formée par dépôt selon les techniques précédemment citées (LPCVD, ALCVD, ALD) afin d'obtenir un oxyde tel que Al₂O₃ ou Ta₂O₅, ou par croissance thermique afin d'obtenir un oxyde SiO₂ ou un oxynitrure ON. On choisira là aussi de préférence un dépôt conforme et un oxyde stable thermiquement.

Comme l'illustre la figure 2G, le procédé se poursuit par un dépôt d'une couche conductrice 8 recouvrant la couche diélectrique 7. Le dépôt sera réalisé selon une ou plusieurs techniques classiques (CVD, LPCVD, ALCVD, ALD) et le ou les matériaux choisis pourront être identiques à celui utilisé pour la couche 6. La couche 8 constitue la deuxième électrode du condensateur.

Les figures 2H et 2I illustrent une mise en forme possible des couches 3, 4, 6, 7 et 8 selon des procédés de gravure classiques. Après gravure, les couches 3, 4 et 6 recouvrent légèrement les bords de l'évidement, et les couches 7 et 8 sont gravées de façon à dégager une partie de la surface supérieure de la couche 6 respectivement sur la gauche et sur la droite. De façon générale, cette étape de mise en forme permet de rendre accessibles des zones sur la première électrode formée par la couche 6 afin de pouvoir prendre des contacts sur cette dernière.

La figure 2J illustre un exemple de prise de contacts sur les deux électrodes du condensateur. Dans cette vue en coupe on peut voir deux vias 9 et 10 reliés à la couche conductrice 6 sur les bords de l'évidement. Ces vias 9 et 10 sont respectivement reliés à des zones métalliques 11 et 12 qui constituent des bornes d'accès à l'électrode inférieure du condensateur. De même, un ensemble de vias 13 et 14 relient la couche conductrice 8 à une zone métallique 17 qui constitue une borne d'accès à l'électrode supérieure du condensateur. De façon plus générale, la position et le nombre de contacts seront définis en fonction de la résistance d'accès souhaitée aux électrodes du condensateur. On pourra par exemple prévoir des ouvertures dans la couche conductrice 8 au dessus de l'évidement afin d'augmenter le nombre de contacts avec l'électrode inférieure.

L'ordre des étapes du procédé décrit précédemment peut être modifié. On pourra notamment choisir de mettre en forme les couches 3, 4 et 6 avant de procéder au dépôt des couches 7 et 8.

A titre d'exemple non limitatif, les différents éléments du condensateur selon l'invention pourront avoir les caractéristiques suivantes :
- couche isolante 1 : SiO₂ obtenu par croissance thermique d'une épaisseur de 500 nm ;
- couche conductrice 4 : silicium polycristallin dopé, épaisseur 100 nm ;
- tranchées d'une largeur minimale de 0,3 µm et séparées d'au moins 0,3 µm ;
- couche conductrice 6 : silicium polycristallin, épaisseur 50 nm ;
- couche diélectrique 7 : SiO₂, épaisseur 40 nm ;
- couche conductrice 8 : silicium polycristallin, épaisseur 60 nm.

Avec les caractéristiques de condensateur précédemment décrites, il est possible d'atteindre une capacité spécifique de 30 à 100 nF/mm², ceci étant à comparer à la capacité surfacique d'un condensateur intermétallique plan, réalisé avec les mêmes matériaux, de 2 à 5 nF/mm².

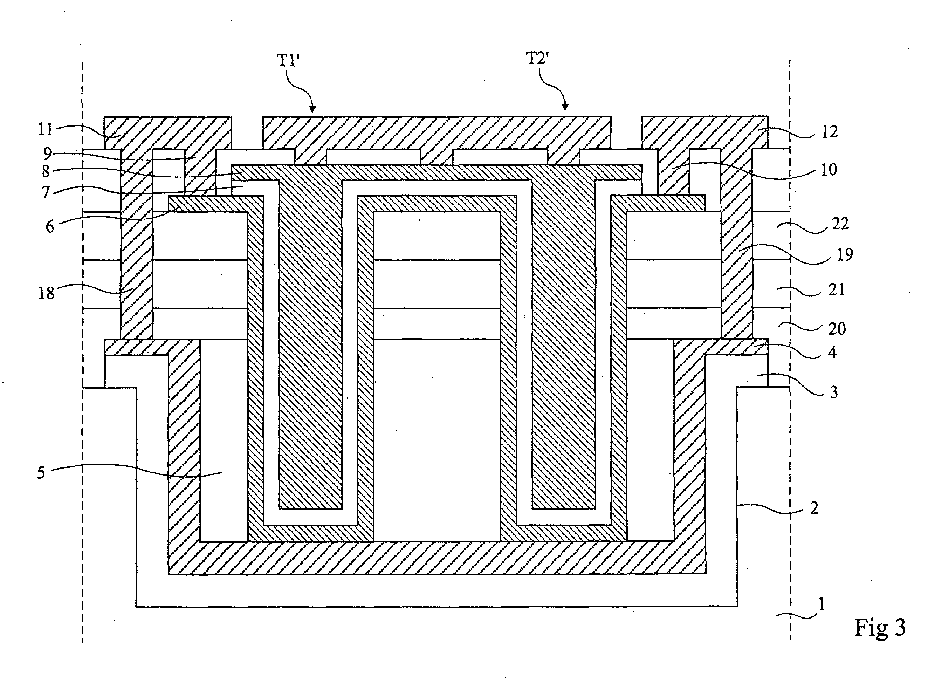

La figure 3 est une vue en coupe schématique d'un condensateur selon une variante de réalisation de la présente invention. Le procédé d'obtention d'un condensateur reprend l'ensemble des étapes du procédé décrit en relation avec les figures 2A à 2J, auxquelles on rajoute des étapes de formation de couches isolantes successives 20, 21 et 22 entre l'étape de formation de la couche de remplissage 5 et l'étape de formation de la couche conductrice 6. Les couches isolantes 20, 21, 22 recouvrent ainsi la couche 5. Les couches isolantes seront de façon classique des couches isolantes intermétalliques d'un circuit intégré classique. Des tranchées T₁' et T₂' traversent la couche 5 comme les tranchées T₁ et T₂ ainsi que les couches isolantes 20, 21, 22. La hauteur des tranchées est donc augmentée de l'épaisseur de l'ensemble des couches isolantes intermétalliques 20, 21 et 22 et la capacité spécifique du condensateur augmente. On pourra aussi choisir de limiter la profondeur de l'évidement et donc de simplifier l'étape consistant à creuser l'évidement tout en conservant une capacité spécifique suffisante. Un évidement moins profond permet également de diminuer globalement la résistance d'accès à l'électrode inférieure. A titre d'exemple, le condensateur en figure 3 comprend deux vias 18 et 19 reliant respectivement les zones 11 et 12 à la couche conductrice 4 respectivement sur les bords gauche et droit.

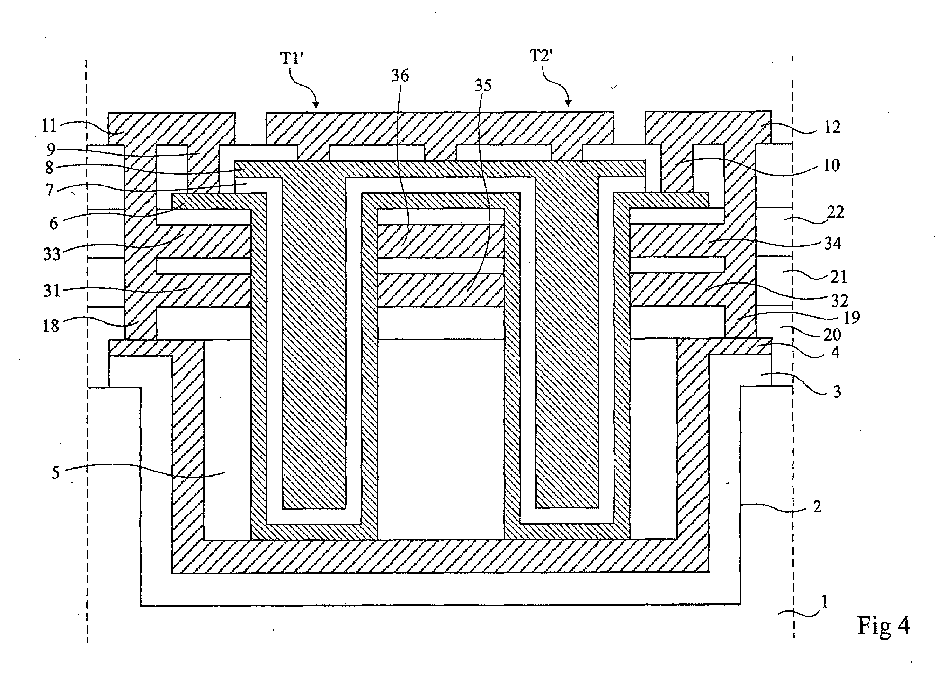

La figure 4 est une vue en coupe schématique d'un condensateur selon une seconde variante de réalisation de la présente invention. Le procédé de réalisation reprend le procédé décrit en relation avec la figure 3 en ajoutant la formation de couches métalliques entre les différentes étapes de formation des couches diélectriques intermétalliques d'un circuit intégré standard. Le condensateur représenté en figure 4 comprend donc des couches métalliques 31, 32, 33 et 34 reliant la couche conductrice 6 du condensateur aux bornes d'accès de l'électrode inférieure du condensateur. Des couches métalliques 35 et 36 relient les parois de deux tranchées successives. Ces couches métalliques 31 à 36 permettent de diminuer fortement la résistance d'accès de l'électrode inférieure du condensateur. Cette seconde variante de réalisation nécessite néanmoins un procédé de gravure de tranchées en plusieurs étapes car il faut pouvoir graver des matériaux différents tels que des isolants, des métaux, des matériaux diélectriques ou semiconducteurs.

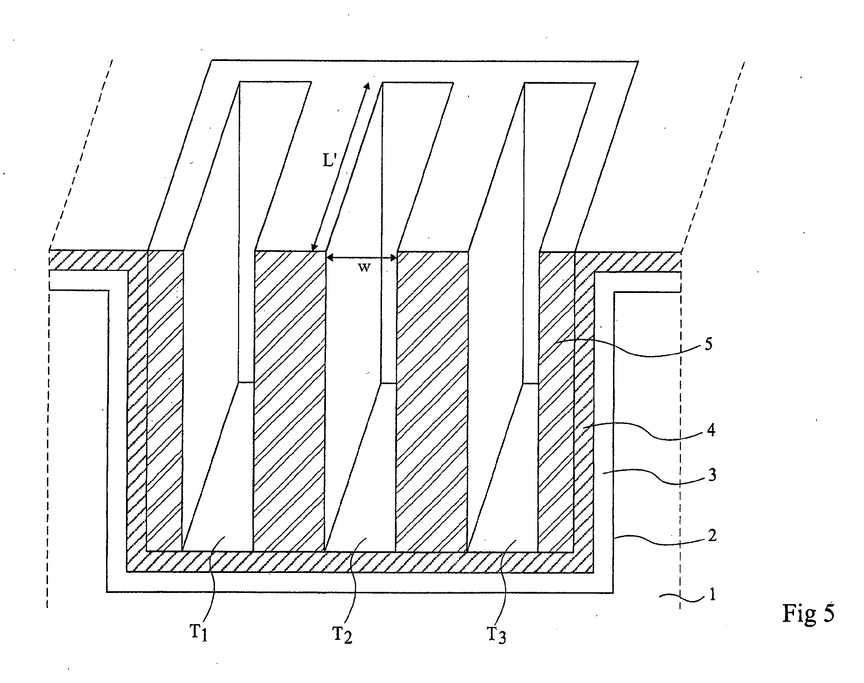

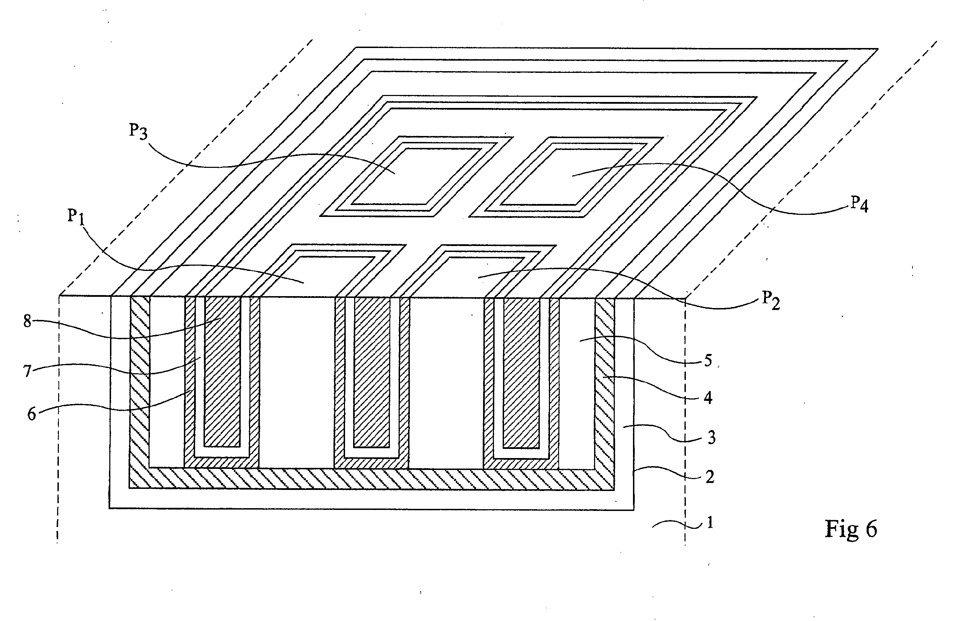

Les figures 5 et 6 sont des vues en perspective de dessus d'exemples de réalisation d'un condensateur selon la présente invention.

En figure 5, seuls l'évidement et les couches 3 à 5 du condensateur sont représentés. L'évidement 2 contient plusieurs tranchées parallèles de largeur W et de longueur L, L étant supérieure à W. Seule une partie de la longueur L' est représentée en figure 5.

En figure 6, seuls l'évidement et les couches 3 à 8 du condensateur sont représentés. La partie horizontale en vue de dessus correspond à une section à mi-hauteur de l'évidement 2. La gravure des tranchées dans l'évidement a été réalisée de façon à former dans la couche de remplissage 5 un ensemble de pylônes disjoints P₁, P₂, P₃ et P₄ de base rectangulaire dans l'évidement. L'espace entre ces pylônes P₁ à P₄ est recouvert par les couches 6 à 8. Les fonds de chaque tranchée sont reliés entre eux. Cet exemple de réalisation permet d'optimiser la capacité spécifique du condensateur.

Néanmoins, on pourra choisir de réaliser des condensateurs selon les exemples représentés en figures 5 et 6 ou toute autre forme en fonction notamment des contraintes du procédé de fabrication utilisé. En effet, la gravure et le remplissage des tranchées peuvent être plus ou moins aisés en fonction de la forme des tranchées, de leur dimension et de l'espacement entre ces dernières. Selon la forme choisie, on pourra obtenir une plus ou moins grande densité spécifique.

De plus, l'homme de l'art saura aisément définir la surface optimale de l'évidement permettant d'obtenir la meilleure capacité spécifique en tenant compte notamment du phénomène de creusement (dishing) pouvant apparaître lors du polissage mécano-chimique de la couche de remplissage. Dans le cas d'un creusement, la hauteur résultante des tranchées peut être diminuée vers le centre de l'évidement et la capacité du condensateur réduite. On peut ainsi envisager de réaliser un évidement de petite taille contenant une seule tranchée. Cependant, la capacité spécifique maximale sera a priori obtenue avec des évidements contenant plusieurs tranchées car l'écartement requis entre les évidements peut amener à réduire beaucoup la capacité spécifique globale dans le cas où plusieurs évidements sont utilisés pour réaliser un seul condensateur.

Un avantage majeur d'un condensateur selon la présente invention est que sa capacité spécifique est très grande.

Un autre avantage d'un condensateur selon la présente invention est que la résistance d'accès aux électrodes peut être très faible.

Un autre avantage d'un condensateur selon la présente invention est que le potentiel de chacune des deux électrodes peut être choisi indépendamment des autres potentiels du circuit.

Bien entendu, la présente invention est susceptible de diverses variantes et modifications qui apparaîtront à l'homme de l'art. En particulier, les exemples numériques indiqués précédemment sont liés à une technologie de fabrication particulière. Ils ne sont en aucun cas limitatifs. En outre, l'homme de l'art saura choisir la forme des tranchées d'un condensateur selon la présente invention ainsi que la taille et le nombre d'évidements utilisés. L'homme de l'art saura également choisir et adapter les matériaux utilisés et leur dimension en fonction des contraintes d'une technologie de fabrication particulière (stabilité thermique, contraintes, etc.) et des performances recherchées.

## Revendications

1. Procédé de fabrication d'un condensateur dans un substrat, comprenant les étapes suivantes:
a) creuser un évidement (2) dans le substrat (1) ;
b) former une première couche conforme d'un matériau isolant (3);
c) former une deuxième couche conforme conductrice (4) ;
d) former une troisième couche de matériau conducteur ou isolant (5) remplissant l'évidement ;
e) creuser des tranchées (T₁, T₂) dans la troisième couche, sur toute la hauteur de cette dernière ;
f) déposer une quatrième couche (6) d'un matériau conducteur ;
g) former une cinquième couche (7) d'un matériau diélectrique ; et
h) déposer une sixième couche (8) d'un matériau conducteur.

2. Procédé selon la revendication 1, comprenant entre les étapes d) et e) les étapes suivantes:
déposer une ou plusieurs couches de matériaux isolants (20, 21, 22) correspondant à des couches isolantes intermétalliques ; et
graver des tranchées (T₁', T₂') dans lesdites une ou plusieurs couches de matériaux isolants.

3. Procédé selon la revendication 2, comprenant entre les étapes de dépôt et de gravure les étapes suivantes:
déposer une ou plusieurs couches de matériaux conducteurs (31 à 36) correspondant à des couches métalliques d'interconnexion ; et
graver des tranchées (T₁', T₂') dans lesdites une ou plusieurs couches de matériaux conducteurs.

4. Condensateur réalisé dans un substrat comprenant:
un évidement (2) creusé dans un substrat (1) ;
une première couche (3) d'un matériau diélectrique recouvrant les parois, le fond et les bords de l'évidement ;
une deuxième couche (4) d'un matériau conducteur recouvrant la première couche ;
une troisième couche (5) d'un matériau conducteur ou isolant remplissant l'évidement ;
des tranchées (T₁, T₂) traversant la troisième couche;
une quatrième couche (6) d'un matériau conducteur recouvrant les parois, les fonds ainsi que les intervalles entre ces tranchées et les bords de celles-ci ;
une cinquième couche (7) d'un matériau diélectrique recouvrant la quatrième couche ; et
une sixième couche (8) d'un matériau conducteur recouvrant la cinquième couche.

5. Condensateur selon la revendication 4, comprenant:
une ou plusieurs couches de matériaux isolants (20, 21, 22) correspondant à des couches isolantes intermétalliques ; et
des tranchées (T₁', T₂') traversant lesdites une ou plusieurs couches de matériaux isolants.

6. Condensateur selon la revendication 5, comprenant une ou plusieurs couches de matériaux conducteurs (31 à 36) correspondant à des couches métalliques d'interconnexion ; et des tranchées (T₁', T₂') traversant lesdites une ou plusieurs couches de matériaux conducteurs.

## Claims

1. A method for manufacturing a capacitor in a substrate, comprising the steps of:
a) digging a recess (2) into the substrate (1);
b) forming a first conformal layer of an insulating material (3);
c) forming a second conformal conductive layer (4);
d) forming a third layer of conductive or insulating material (5) filling up the recess;
e) digging trenches (T₁, T₂) into the third layer, across the entire height thereof;
f) depositing a fourth layer (6) of a conductive material;
g) forming a fifth layer (7) of a dielectric material; and
h) depositing a sixth layer (8) of a conductive material.

2. The method of claim 1, comprising between steps d) and e) the steps of:
depositing one or several layers of insulating materials (20, 21, 22) corresponding to intermetallic insulating layers; and
etching trenches (T₁', T₂') into said one or several layers of insulating materials.

3. The method of claim 2, comprising, between the steps of depositing and etching the steps of:
depositing one or several layers of conductive materials (31 to 36) corresponding to interconnection metal layers; and
etching trenches (T₁', T₂') into said one or several layers of conductive materials.

4. A capacitor formed in a substrate comprising:
a recess (2) dug into a substrate (1);
a first layer (3) of a dielectric material covering the walls, the bottom and the edges of the recess;
a second layer (4) of a conductive material covering the first layer;
a third layer (5) of a conductive or insulating material filling the recess;
trenches (T₁, T₂) crossing the third layer;
a fourth layer (6) of a conductive material covering the walls, the bottoms as well as the intervals between these trenches and the edges thereof;
a fifth layer (7) of a dielectric material covering the fourth layer; and
a sixth layer (8) of a conductive material covering the fifth layer.

5. The capacitor of claim 4, comprising:
one or several layers of insulating materials (20, 21, 22) corresponding to intermetallic insulating layers; and
trenches (T₁', T₂') crossing said one or several layers of insulating materials.

6. The capacitor of claim 5, comprising one or several layers of conductive materials (31 to 36) corresponding to metal interconnection layers; and trenches (T₁', T₂') crossing said one or several layers of conductive materials.

## Patentansprüche

1. Verfahren zur Herstellung eines Kondensators in einem Substrat, wobei folgende Schritte vorgesehen sind:
a) Graben einer Ausnehmung (2) in das Substrat (1);
b) Formen einer ersten konformen Schicht aus einem Isoliermaterial (3);
c) Formen einer zweiten konformen leitenden Schicht (4);
d) Formen einer dritten Schicht aus leitendem oder isolierendem Material (5) zum Auffüllen der Ausnehmung;
e) Graben von Gräben (T₁, T₂) in die dritte Schicht über die gesamte Höhe derselben;
f) Abscheiden einer vierten Schicht (6) aus einem leitenden Material;
g) Formen einer fünften Schicht (7) aus einem di-elektrischen Material; und
h) Abscheiden einer sechsten Schicht (8) aus einem leitenden Material.

2. Verfahren nach Anspruch 1, wobei zwischen den Schritten d) und e) die folgenden Schritte vorgesehen sind:
Abscheiden von einer oder mehreren Schichten aus Isoliermaterialien (20, 21, 22) entsprechend der intermetallischen Isolierschichten; und
Ätzen von Gräben (T₁', T₂') in eine oder mehrere der erwähnten Schichten aus Isoliermaterialien

3. Verfahren nach Anspruch 2, wobei zwischen den Schritten des Abscheidens und des Ätzens die folgenden Schritte vorgesehen sind:
Abscheiden von einer oder mehreren Schichten aus leitenden Materialien (31 bis 36), entsprechend den Zwischenverbindungsmetallschichten; und
Ätzen von Gräben (T₁', T₂') in die erwähnte eine oder mehrere Schichten aus leitenden Materialien

4. Ein Kondensator, gebildet in einem Substrat, wobei Folgendes vorgesehen ist:
eine Ausnehmung (2), gegraben in einem Substrat (1);
eine erste Schicht (3) aus einem di-elektrischen Material, und zwar die Wände, den Boden und die Kanten der Ausnehmung abdeckend;
eine zweite Schicht (4) aus einem leitenden Material, die erste Schicht abdeckend;
eine dritte Schicht (5) aus einem leitenden oder isolierenden Material, die Ausnehmung füllend;
Gräben (T₁, T₂), welche die dritte Schicht kreuzen;
eine vierte Schicht (6) aus einem leitenden Material, die Wände, die Böden und auch die Intervalle zwischen den Gräben und den Kanten abdeckend; eine fünfte Schicht (7) aus einem di-elektrischen Material, die vierte Schicht abdeckend; und
eine sechste Schicht (8) aus einem leitenden Material, die fünfte Schicht abdeckend.

5. Kondensator nach Anspruch 4, wobei Folgendes vorgesehen ist:
eine oder mehrere Schichten aus isolierenden Materialien (20, 21, 22), entsprechend den intermetallischen lsolierschichten, und
Gräben (T₁', T₂'), welche die erwähnten eine oder mehreren Schichten aus Isoliermaterialien kreuzen.

6. Kondensator nach Anspruch 5, wobei Folgendes vorgesehen ist:
eine oder mehrere Schichten aus leitenden Materialien (31 bis 36), entsprechend den Metallzwischenverbindungsschichten; und
Gräben (T₁', T₂'), welche die erwähnten eine oder mehreren Schichten aus leitenden Materialien kreuzen
